# EUROPEAN PATENT SPECIFICATION

(11) **EP 3 282 294 B1**
(45) Date of publication and mention of the grant of the patent: **15.04.2020**
(21) Application number: 17161526.3
(22) Date of filing: 17.03.2017
(51) Int. Cl.: G02B 5/18, C23C 16/455

(54) **HIGH RESOLUTION FULL MATERIAL FRESNEL ZONE PLATE ARRAY AND PROCESS FOR ITS FABRICATION**
HOCHAUFLÖSENDES VOLLMATERIAL-FRESNEL-ZONENPLATTEN-ARRAY UND VERFAHREN ZU DESSEN HERSTELLUNG
RÉSEAU DE PLAQUES À ZONES DE FRESNEL HAUTE RÉSOLUTION À MATÉRIAU PLEIN ET SON PROCÉDÉ DE FABRICATION

(30) Priority: 12.08.2016 EP 16184001
(43) Date of publication of application: 14.02.2018
(73) Proprietor: Max-Planck-Gesellschaft zur Förderung der Wissenschaften e.V., 80539 München (DE)
(72) Inventor: Sanli, Umut, Tunca, 70567 Stuttgart (DE); Keskinbora, Kahraman, 70569 Stuttgart (DE); Schütz, Gisela, 70195 Stuttgart (DE); Jiao, Chengge, 5612 BD, Eindhoven (NL)
(74) Representative: Hannke, Christian

(56) References cited:
- WO-A2-2004/012236
- US-A1- 2012 258 243
- US-A1- 2013 280 421
- US-B1- 7 365 918
- LEJEUNE M ET AL: "Ink-jet printing of ceramic micro-pillar arrays", JOURNAL OF THE EUROPEAN CERAMIC SOCIETY, ELSEVIER SCIENCE PUBLISHERS, BARKING, ESSEX, GB, vol. 29, no. 5, 1 March 2009 (2009-03-01), pages 905-911, XP025884294, ISSN: 0955-2219, DOI: 10.1016/J.JEURCERAMSOC.2008.07.040 [retrieved on 2008-09-23]

## Description

The invention relates to a high resolution full material Fresnel Zone Plate array, a process for its fabrication and an apparatus for producing high resolution full material Fresnel Zone Plate (FZP) arrays.

X-ray microscopy has been shown to be an important imaging technology. In a first approach, the resolution of a microscope is limited by the wavelength of the used radiation. In comparison to visible light, X-rays provide the advantage of a shorter wavelength, potentially allowing higher resolutions. However, refraction or reflection of X-rays by conventional lenses is very limited. Thus, the diffractive Fresnel zone plates have been established as the most popular and successful focusing devices for focusing X-rays, especially in the soft X-ray energies. A (full material) Fresnel Zone Plate is a diffractive lens, composed of multilayers of at least two materials to act as the zones of the FZP. In view of the rapid development of technologies in the nanometer range and the significant effects thereof for the development of science, in particular for use in biology, chemistry and in all life and earth sciences a further improvement of X-ray microscopy and the focusing devices (e.g. Fresnel zone plates) is sought. Furthermore, a comparatively cheap and parallel production process for FZP is in demand.

Furthermore, one of the major challenges in X-ray optics is to create optics that can focus hard X-rays down to nanometer resolutions with high diffraction efficiency. The fabrication of such an optic has been a very demanding task because it requires lenses with very high aspect ratios with zones tilted to Bragg angle. Among the possible options, multilayer type (full material) Fresnel zone plates (ML-FZP) would have been one of the best suited for accomplishing this challenge, as virtually unlimited aspect ratios can be fabricated, if zones could be tilted to Bragg angle. For the fabrication of an ML-FZP it starts with a centimeter long glass fiber substrate which has a diameter of e.g. 30 microns. Onto this substrate alternating multilayers are deposited by the atomic layer deposition technique (ALD). This has been patented under US 9360603 B2. The ALD allows angstrom level precision in deposition thickness, and excellent conformality through its sequential, self-limiting surface reactions. This also eliminates the need for rotating the glass fiber that sputtered-sliced ML-FZPs suffer. Since the need for rotation of the substrate is eliminated, the accuracy could be increased and the uniformity and the resolution of the FZP could be increased significantly. Document US 2013/0280421 A1 discloses FZP fabricated by deposition inside capillaries. Document US 2012/0258243 A1 discloses a single full material FZP precursor in the form of a micro-pillar. Document "Ink-jet printing of ceramic micro-pillar arrays", by M. Lejeune et a., Journal of the European Ceramic Society, 29(2009), pp. 905-901 discloses a plurality of micro-pillars on a common carrier.

This process allows simultaneous production of virtually unlimited number of ML-FZPs from the intermediate product since many single FZPs could be sliced from the multitude of deposited glass fiber in the desired thickness e.g. via a focused ion beam.

However, qualities such as the glass fiber surface roughness, circularity and taper angle of the glass fiber, as a substrate material cannot be easily controlled. Thus, alternative methods of production of a plurality of these or similar intermediate products are sought. Consequently the object of the invention is to make available a method for producing a plurality of these or similar intermediate products as well as an array of these or similar intermediate products, which allows a simple and inexpensive production of a plurality of Fresnel zone plates, with or without zones tilted to Bragg angle, having a high resolution, high efficiency, through a high or even selectable aspect ratio and error-free layers or zones.

This object is attained by a Fresnel Zone Plate array according to claim 1, a process of its fabrication according to claim 6 and an apparatus for its fabrication according to claim 15. The Fresnel Zone Plate array, the process of its fabrication and the apparatus for its fabrication are described in more detail in the following.

A major aspect of the invention is a full material Fresnel Zone Plate precursor array which comprises a plurality of full material Fresnel Zone Plate precursors arranged on a common carrier.

In a preferred embodiment the full material Fresnel Zone Plate precursor array have controlled tapering angles. In a further preferred embodiment these tapering angles differ between some of the Fresnel Zone Plate precursors arranged on the same common carrier. This means that at least two Fresnel Zone Plate precursors arranged on the same common carrier can provide different tapering angles. Preferably, these Fresnel Zone Plate precursors are tilted to different Bragg angles optimized for different energies.

In a preferred embodiment of the full material Fresnel Zone Plate precursor array the full material Fresnel Zone Plate precursors are spaced apart from each other on the common carrier.

The full material Fresnel Zone Plate precursor array may be characterized in that the central axis of the full material Fresnel Zone Plate precursors are arranged parallel to each other on the common carrier.

In a preferred embodiment of the full material Fresnel Zone Plate precursor array the central axis of the full material Fresnel Zone Plate precursors are arranged parallel to the surface normal of the common carrier. Thus, they are arranged perpendicular to a surface of the common carrier. More preferably this surface of the common carrier is its uppermost surface.

In a preferred embodiment of the full material Fresnel Zone Plate precursor array the central axis of the full material Fresnel Zone Plate precursors are arranged perpendicular to the longitudinal direction of the common carrier. The longitudinal direction of the common carrier is understood as the direction along which the carrier provides the widest extent.

In a preferred embodiment of the full material Fresnel Zone Plate precursor array the central axis of the full material Fresnel Zone Plate precursors comprise the same material as the common carrier.

In the following the terms "Fresnel Zone Plate precursor array" and "Fresnel Zone Plate array" are used synonymously, because - as described later - it can be used as optics as a whole or one or more Fresnel Zone Plate(s) can be sliced out of the Fresnel Zone Plate precursor array to provide one or more Fresnel Zone Plate(s). The Fresnel Zone Plate precursor array (or Fresnel Zone Plate array) may comprise a plurality of pillars onto which alternating layers of material are deposited. These deposited layers form the different zones of the FZP. Preferably, the pillars are fixed on a common carrier and are immoveable with respect to each other.

In a preferred embodiment the common carrier is a wafer. However, the substrate is not limited to Si wafers. In a preferred embodiment the common carrier comprises at least one material selected from a group comprising metals, glass, oxides, alloys, sulfates and metal oxides.

In a further preferred embodiment the common carrier comprises at least one material selected from a group comprising glass, ((mono) crystalline) silicon, aluminum oxide or gold. It could be shown that some substrates, especially an Au substrate can significantly improve fabrication speed over a Si substrate.

In a preferred embodiment single crystalline Au is used as a material for the common carrier. This material allows for improved milling rates. The sputter yield of Au is very high compared to silicon. In an even further preferred embodiment the substrate is (111) type Au single crystal. It has been shown that milling out (111) type Au single crystal is about twice as fast as using (100) Au single crystal.

In a preferred embodiment a high Z material is used as a material for the common carrier. One example for such a material is Au. Using Au as a substrate furthermore eliminates the need for an additional beam-stop deposition, which covers the zones with a Pt/C layer via parasitic deposition.

In a preferred embodiment at least one of the full material Fresnel Zone Plate precursors arranged on a common carrier differs from at least one other full material Fresnel Zone Plate precursor arranged on the same common carrier. In contrast to known methods, in which a single FZP or a plurality of FZPs is/are produced by material deposition on a longitudinal substrate (e.g. a wire), the present invention allows for parallel production of a plurality of FZPs which differ in their optical properties. FZP-production with a wire as substrate allows production of more than one single FZP, however this technique only results in FZP with identical diameter and without slanted sidewalls (or different taper angle (α)).

In another preferred embodiment, a film of material deposited onto an X-ray transparent carrier membrane and then used to fabricate the FZP precursors. The carrier membrane material can be Si, Si3N4, carbon related materials such as diamond, diamond like carbon, polycrystalline carbon, and other X-ray transparent material structured to a thickness to facilitate X-ray transparency for a given energy. The deposit can be either low or high Z metallic and non-metallic elements or their compounds or alloys given that they provide high enough diffraction efficiency for that given X-ray energy.

The present invention allows that a plurality of different full material Fresnel Zone Plate precursors are arranged on the same common carrier, each resulting in one or more different FZP(s). The full material Fresnel Zone Plate precursors may differ with respect to each other in parameters selected from a group comprising its diameter (width), taper angle (α), length (height) and material composition.

The present invention allows the realization of arrays of full material FZPs for the first time. In contrast to single FZPs, arrays have the advantage of being installed in X-ray microscopes directly. Preferably, the FZP arrays could be used in hard X-ray FEL's or other hard X-ray microscopes directly. Usage of arrays as a whole will be advantageous when one needs to change the focusing optic either because a different X-ray energy will be used, or like in the case of FEL's where the optic is destroyed after even one shot e.g. due to intense heat load and definitely after several shots as a result of beam damage and a new lens has to be used. Thus, the array can comprise different or similar FZPs. If the FZPs of the same array are different with respect to each other, they can differ independently from each other in length, focal length, taper angle and/or others and may be optimized to different X-ray energies.

For such an application, the produced array of FZPs can be used as is or it can be further processed. In a preferred embodiment the common carrier is changed. In such an embodiment all or some FZPs can be transferred to another substrate or common carrier. In a preferred embodiment the top surfaces of the pillars are sliced away. In an even further preferred embodiment the newly generated top surfaces of the pillars are polished.

In a preferred embodiment the pillars are attached with their top surfaces onto another substrate and all or some pillars are detached from their original substrate. Thus, the arrangement of the FZPs with respect to each other remains constant but their upper and lower surfaces can be accessible. Thus, manipulation of these surfaces with (additional) other processes (e.g. polishing) is possible.

A further major aspect of the invention is a method for producing a full material Fresnel Zone Plate precursor array. This method comprises the steps
a) Providing a common carrier comprising a plurality of full material Fresnel Zone Plate precursors,
b) Deposition of alternating layers of at least two different materials onto at least some of the micro-pillars.

In a preferred embodiment, the full material Fresnel Zone Plate precursors are micro-pillars.

In an alternative embodiment the full material Fresnel Zone Plate precursors are cylindrical holes. They are preferably milled out/or laser written, similar to capillaries. This embodiment provides the advantage that the FZP layers could be deposited from outer to inner. This can be advantageous since the outermost layer, which is crucial for the resolution of the FZP, is deposited first and no inaccuracies caused by other layers can propagate to the outermost layer.

In a preferred modification of this method the plurality of full material Fresnel Zone Plate precursors is produced in the common carrier by at least one process selected from the group comprising
- Focused ion beam (FIB) milling,
- Plasma focused ion beam (Plasma-FIB) milling,
- Spin-coating combined with Direct Laser writing or two photon photopolymerization or any other microprinting method,
- Direct laser ablation,
- A combination of any optical, electron, ion beam lithography or any directed self-assembly or self-assembly method to form a mask layer followed by re-active ion etching (RIE), deep reactive ion etching (DRIE) or a chemical etching method.

It has been found that the full material Fresnel Zone Plate precursors could be formed via focused ion beam (FIB) in a common substrate, e.g. a wafer. However, the milling of the pillars is not limited to the conventional FIBs. As alternatives to or in addition to the above-mentioned techniques any of the recent energetic, heavy ion FIB technologies can be utilized.

It is preferred that at least some of the full material Fresnel Zone Plate precursors are produced to be parallel with respect to each other. This arrangement allows a high density of full material Fresnel Zone Plate precursors on the common carrier. Furthermore this arrangement can easily be realized by the techniques mentioned above.

In a preferred variation of the method the deposition of the alternating layers is performed via selective or non-selective, atomic layer deposition (ALD). ALD has the disadvantage that it is quite slow. However, ALD ensures uttermost precision in thickness control.

In a preferred variation of the method, the deposition of the alternating layers is performed simultaneously on a plurality of full material Fresnel Zone Plate precursors. Since some techniques, e.g. ALD, are quite slow and time consuming, it is desired to overcome this drawback. It has been found that this disadvantage can be overcome if a plurality of full material Fresnel Zone Plate precursors can be treated by this method simultaneously. Since for ALD the material for the different layers is provided in form of gaseous precursors which can easily reach any surface of the common carrier, these precursors will reach all full material Fresnel Zone Plate precursors arranged on one or even more common carrier/s which is/are treated by ALD if the material is provided in excess. After deposition of the respective material, the surface of all full material Fresnel Zone Plate precursors will be covered by this material.

To avoid deposition of material on all accessible surfaces of the one or even more common carrier within a treatment chamber, some surfaces may be covered by a protection layer or coating, which avoids adhesion of the (gaseous) precursor molecules. Thus, the material will not be deposited on these surfaces during the deposition step.

In a preferred variation of the method it further comprises the step of
c) detaching at least one full material Fresnel Zone Plate precursor, preferably a micro-pillar from the common carrier after deposition of the alternating layers on this full material Fresnel Zone Plate precursor, e.g. a micro-pillar.
By this additional step a full material Fresnel Zone Plate precursor can be separated from the common carrier (and all other full material Fresnel Zone Plate precursors arranged on it) and handled individually. This allows for production of one or more Fresnel Zone Plates out of this single full material Fresnel Zone Plate precursor (e.g. micro-pillar) onto which alternating layers of at least two different materials have been deposited.

In a preferred variation of the method the method further comprises the step of
d) slicing a full material Fresnel Zone Plate out of a full material Fresnel Zone Plate precursor after deposition of the alternating layers on it.

Usually the longitudinal axis of a full material Fresnel Zone Plate precursor is much longer than the desired thickness of a single Fresnel Zone Plate. Thus, it is possible that a plurality of Fresnel Zone Plates can be sliced from one single full material Fresnel Zone Plate precursor, e.g. a single micro-pillar. Accordingly it is preferred, that a plurality of Fresnel Zone Plates is sliced out of a full material Fresnel Zone Plate precursor or micro-pillar after deposition of the alternating layers on it.

In a further preferred variation of the method, slicing is performed by means of an ion beam.

After detaching the micro-pillar from the common carrier, it is preferred that the detached full material Fresnel Zone Plate precursor (e.g. micro-pillar) is bound to a mount. Preferably, such a mount is a TEM mount. Preferably, the detached full material Fresnel Zone Plate precursor is bound to the mount via ion beam induced metal deposition, most preferably via ion beam induced Pt deposition.

It is possible that steps a) and b) are performed independently from each other. Since the techniques of steps a) and b) differ from each other, it is possible that one or more common carriers comprising a plurality of full material Fresnel Zone Plate precursors is/are produced and stored at suitable conditions. Even transport from one production site to another one is possible if the suitable storage conditions can be maintained during transport. Afterwards, step b) can be performed independently from step a). Eventually the common carrier may be cleaned or pretreated before the deposition of the alternating layers of the at least two different materials onto the full material Fresnel Zone Plate precursor can be performed.

In a preferred variation of the method, the common carrier comprising the full material Fresnel Zone Plate precursors is pretreated before step b) is performed. Preferably, this pretreatment comprises the step of masking areas onto which no material should be deposited during step b). As described later with reference to the figures it is possible that only some surfaces of the full material Fresnel Zone Plate precursors, e.g. the micro-pillars, are not masked. For example it is possible that the micro-pillars have the form of a right circular cylinder or a section of a cone. In these special cases it is preferred that only the area of the side of this cylinder or cone section is not masked so that deposition of the alternating layers is only performed on these sides. However, also for other geometries of the full material Fresnel Zone Plate precursor or micro-pillars it is preferred that only the sidewalls are not masked and the alternating layers are deposited thereon.

The sidewalls of the full material Fresnel Zone Plate precursors or micro-pillars can be (independently from the mask) inclined/slanted with respect to its central axis. Thus, the micro-pillars can be cones or cone sections. In a preferred embodiment, the full material Fresnel Zone Plate precursors comprise a sidewall which is inclined with respect to its central axis and a planar top surface. Thus, the full material Fresnel Zone Plate precursors are preferably sections of a cone.

It is preferred that the micro-pillars comprise a sidewall which may or may not be inclined with respect to its central axis, a top surface, which is preferably circular, and a lower surface, which is adhered to the common carrier.

In a further preferred embodiment, each micro-pillar is arranged in a recess of the common carrier. The recess has a bottom surface. Preferably the micro-pillar is adhered to this bottom surface. In an even more preferred embodiment, the micro-pillar is arranged perpendicular to this bottom surface. In an even more preferred embodiment, the micro-pillar is arranged at the center of the bottom surface.

The recess in which the micro-pillar is arranged can have several forms. In a preferred embodiment, the recess is a cylinder. In an even more preferred embodiment, the cylinder is a right cylinder. This embodiment is preferred because formation of (more or less) right cylinders in the common carrier by the techniques mentioned above is quite easy. Since it is desired that in step b) the alternating layers are deposited on all sidewalls of each micro-pillar in the same thickness, it is even more preferred that the recess is a right circular cylinder and the micro-pillar is arranged in the center of such a right circular cylinder along its central axis. Thus, the distance between the micro-pillar and the inner sidewalls of the surrounding right circular cylinder is the same in all directions and the same number of layers can be deposited over the entire sidewall surface of a micro-pillar.

If an ion beam is used for producing the recesses and micro-pillars in step a) an ion beam current between 1 pA and 1.3 µA is preferred, preferably an ion beam current between 100 pA and 1 µA, more preferably an ion beam current between 1 nA and 700 nA, especially of about 60 nA or especially of about 180 nA or especially of about 480 nA is used, depending on the material of the common carrier, the processing time, the precursor height, and the desired tapering angle. Preferably, the pillars are fabricated through a multi step milling process. More preferably, during a first, so-called "rough milling step" with a high current the rough structure of the array is milled. During a following further step the fine structure of the Array, the recesses and/or the individual pillars is milled. Especially exact milling of the tapering angles is performed at low ion beam currents and/or smaller PFIB spot size.

In a preferred method an ion beam energy between 5 keV and 100 keV, preferably between 10 keV and 50 keV especially of 30 keV is used.

In a preferred embodiment, the produced FZPs are for use with operating energy E between 150 eV and 900 keV, more preferably between 1000 eV and 80 keV, especially of 1200 eV to 17 keV. The operating energy E can even be higher if Fresnel Zone Plates for applications in high energy radiation, such as gamma radiation, are used.

In a preferred embodiment, a produced FZP has a diameter between 20 µm and 500 µm, more preferably between 40 µm and 150 µm, especially of 60 µm or 100 µm.

Preferably the FZP has a height between 100 nm and 5 mm, more preferably between 200 nm and 100 µm, especially of about 5 µm.

According to another embodiment of the method in step b) preferably between 30 and 50000, preferably between 35 and 10000, more preferably between 400 and 8000, especially between 600 and 6000 layers of alternating materials are deposited on each micro-pillar. Each layer may comprise a plurality of layers of the same material. Since by ALD ideally only a single atomic layer is deposited in each cycle the ALD-process has eventually to be performed repeatedly to provide the desired thickness of a single material-layer or period.

Since the thickness of the outermost period of the FZP is crucial with respect to its resolution, it is preferred that the outermost period or layer has a width between 0.01 nm and 1 µm, preferably between 1 nm and 250 nm, more preferably between 5 nm and 120 nm, especially of about 10 nm.

FZP with the above-mentioned characteristics are most suitable for applications in X-ray radiation or extreme ultraviolet radiation, especially for focusing X-ray radiation or extreme ultraviolet radiation since the aforementioned dimensions are of the range of the wavelengths of the used radiations so that they are suitable for use in those applications.

FZPs with slanted sidewalls, with or without altering the line to space ratio of the zones allows the appearance of higher order focus with resolutions multiple times as high as the first order depending on the diffraction order and therefore a better resolution and efficiency than known FZPs without such slanted sidewalls of the zones.

The ALD also allows the line-to-space ratio to be altered freely. This combined with a controlled tilt angle and high optical thickness, higher diffraction orders, preferably 2^{nd}, 3^{rd}, 4^{th} 5^{th}, 6^{th} and 12^{th} could become highly efficient. Resolutions much higher than the outermost zone width could be achieved this way. This becomes important for FZPs with very high optical thicknesses, where the alignment of the FZPs in optical axis is crucial.

Preferably the present invention allows the fabrication of full material FZPs with highly controlled tilt angles. The tilt angle is crucial for two reasons:
- It greatly increases the diffraction efficiency of the lens and
- High efficiency sub-10 nm focusing becomes available.
The tilt angle of each pillar in array may be optimized (preferably individually) to different incoming X-ray energies. Thus, the array of FZP allows production of a plurality of different or identical FZPs in a fast and cost efficient manner.

Further goals, advantages, features and applications of the invention arise out of the following description of embodiments of the invention on the basis of the figures. Thereby all features described and shown in the figures alone or in arbitrary reasonable combination provide the subject matter of the invention independent of their conclusion in the claims or its dependency.

It shows:
- Figure 1:: an example of a micro-pillar array fabricated via Plasma FIB milling of single crystalline Si wafer,
- Figure 2:: an individual micro-pillar in more detail,
- Figure 3:: a Plasma FIB fabricated micro-pillar with 5° taper angle,
- Figure 4a):: micro pillars fabricated on a glass substrate via spin coating of a photoresist,
- Figure 4b):: micro pillars fabricated by laser writing via the KLOE Dilase laser writer,
- Figure 5:: a schematic illustration of the fabrication steps of Fresnel Zone Plate arrays with area selective ALD,
- Figure 6:: a schematic illustration of the possible single steps of an ALD-cycle,
- Figure 7.1 - 7.9:: illustrations of individual steps of producing an FZP from a Fresnel Zone Plate array,
- Figure 8:: advantages of the high resolution full material Fresnel Zone Plate array with respect to other techniques,
- Figure 9a) and 9b):: SEM images of one ML-FZP,
- Figure 10a) - 10d):: illustrations of the extremely high accuracy of the zones of the multilayer FZP,
- Figure 11a) and 11b):: a TEM image of an Al₂O₃-SiO₂ Multilayer,
- Figure 12a) and 12b):: an SEM image of a ML-FZP of Al₂O₃-HfO₂,
- Figure 13:: an illustration of the linear correlation of the growth per cycle for the ALD,
- Figure 14a) and 14b):: examples for direct imaging results obtained at BESSY II,
- Figure 15a) and 15b):: illustration of results of diffraction efficiency calculations.

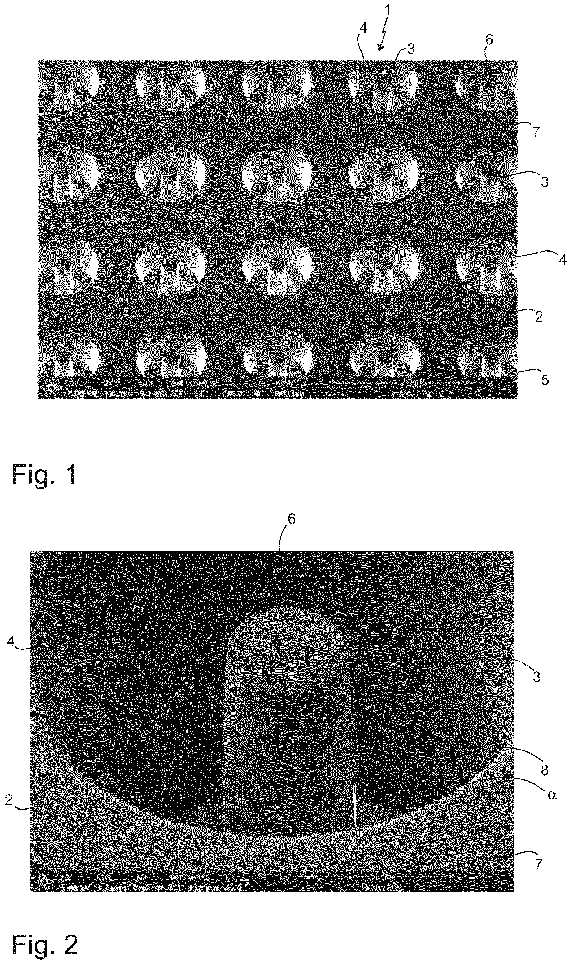

Figure 1 shows an example of a micro-pillar array (1) fabricated via Plasma FIB milling of a common carrier (2), which is in this case a single crystalline Si wafer. Each micro-pillar (3) is located in a recess (4) formed in the common carrier (2). In the shown embodiment the recesses (4) are right circular cylinders which are arranged in lines and rows on the common carrier (2). In the center of each recess (4), a micro-pillar (3) is located. Each micro-pillar (3) stands on a bottom surface (5) of a recess (4) and is oriented along the central axis of the respective cylinder. The depth of each recess (4) is identical to the length of each micro-pillar (3). The top surface (6) of each micro-pillar (3) is arranged in the same plane as the upper surface (7) of the common carrier (2). The tapering angle (not indicated in Fig. 1) of each micro-pillar (3) is 1°. However, the micro-pillar arrays (1) can be fabricated with any other desired tapering angle via the Plasma or other FIB, and allow ML-FZPs to be fabricated with zones tilted to the Bragg angle, paving the way for highly efficient focusing to sub 10 nm resolution.

Figure 2 shows an individual micro-pillar (3) in more detail. Such a pillar provides smooth (side) walls (8), high circularity and a tapering angle (α). Figure 2 further illustrates that between the sidewalls of the micro-pillar (3) and the sidewall of the recess/cylinder (4) there is a certain distance that has to be at least two times larger than the deposition thickness and preferably between 3 or 4 times larger. Thus, material layers can be deposited between these sidewalls. In Figure 2 also the common carrier (2) with its upper surface (7) is shown. Its upper surface (6) of the micro-pillar (3) is arranged on the same plane as the upper surface (7) of the common carrier (2). The pillars (3) produced via PFIB can be even more precise than glass fibers in terms of diameter vs circularity.

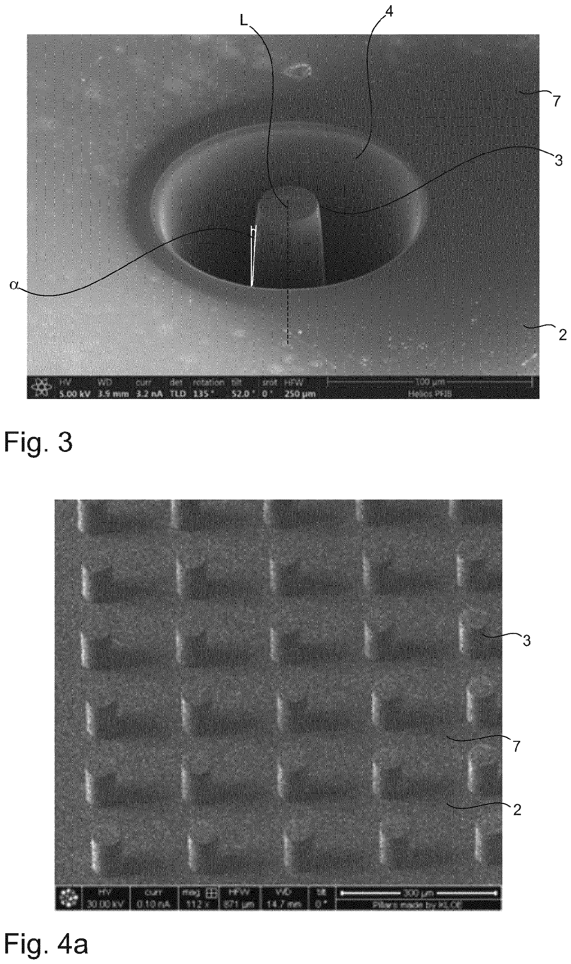

Figure 3 shows another individual micro-pillar (3) in more detail which provides a different taper angle (α) of 5°. The sidewalls are inclined with respect to the central axis (L) by the taper angle (α). This pillar was also fabricated via Plasma FIB. Also the recess/cylinder (4) and the common carrier (2) with its upper surface (7) are shown.

Figure 4a) and b) are showing micro-pillars (3) fabricated via other techniques than FIB. The pillars (3) shown in Fig. 4a) are fabricated on a glass substrate, which serves as a common carrier (2), via spin coating of a photoresist (KCL). Similar to the arrangement of the pillars shown in Fig. 2, the pillars (3) are arranged in lines and rows. However, the pillars are not located in recesses but located on the upper surface (7) of the common carrier (2). In this embodiment, each micro-pillar (3) is a right circular cylinder standing perpendicular on the upper surface (7) of the common carrier (2).

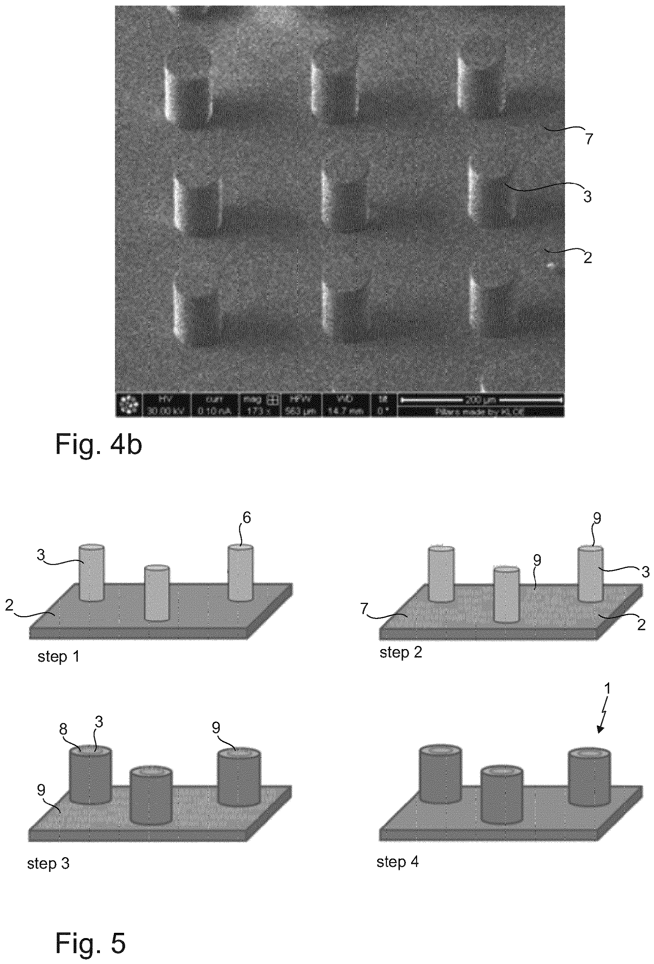

Figure 4b) shows micro-pillars (3) produced by laser writing via the KLOE Dilase laser writer. Similar to the micro-pillars (3) shown in Fig. 4a) these pillars (3) are arranged in lines and rows and not located in recesses but on the upper surface (7) of the common carrier (2).

However, fabrication of micro pillars (3) via FIB is preferred because it easily allows for controlling the tapering angles (α) by varying sputter time, beam energy and beam current. Independent from the above-mentioned techniques but especially when FIB is used, the fabrication of micro pillars (3) can result in controlled circularity, diameter, tilt angle and high surface smoothness.

In a preferred embodiment, Plasma FIB is used. By using Plasma FIB the milling speed can be further enhanced. With Plasma FIB, milling out pillars is about 30 times faster, compared to non-plasma FIB.

In a preferred embodiment single crystalline Au is used as a substrate material for the common carrier (2). This material allows for improved milling rates. The sputter yield of Au is very high. In an even further preferred embodiment the substrate is (111) type Au single crystal. It has been shown that milling out (111) type Au single crystal is about twice as fast as using (100) Au single crystal.

Irrespective of whether pillars (3) or cylindrical holes (4) are milled out/or laser written, circular geometries are preferred. The circularity of the (etched) structures and longer crack propagation lengths due to the trenches around pillars (3) or the (cylindrical) holes (4) may hinder crack propagation, enabling thicker depositions to be done crack-free.

As mentioned above, the step of production of the full material Fresnel Zone Plate precursor array (1) (e.g. the array of micro pillars) is followed by the deposition of alternating material layers onto it. The deposition is preferably performed by ALD. The deposition of alternating layers can be performed via selective or non-selective atomic layer deposition (ALD) and the individual layers act as the zones of the Fresnel zone plate, which can be sliced in a later step as described in detail below.

Thus, this process allows for the first time production of full material FZP (widely also known as multilayer or as sputter sliced) that does not have a micro fiber core. Until now, the micro fiber substrates could be deposited by other techniques (e.g. PLD or magnetron sputtering) than ALD although with more difficulty. However, by the currently disclosed process, highly conformal deposition onto these full material Fresnel Zone Plate precursor arrays (1), e.g. micro-pillar arrays (1) can only be achieved by the ALD. This feature provides big advantages with respect to other techniques (e.g. the sputtered sliced or PLD deposited FZP intermediate products and the resultant FZPs). Here, especially circularity, diameter and tapering angle can be controlled very precisely. If a sputtering technique is to be used for the zones of the FZP, one has to start with a wire because it has to be ultimately symmetric for the following sputter deposition of the material while rotating the substrate wire core. However, rotation always results in errors such as inhomogeneous deposition of the materials.

In a preferred embodiment the arrangement of the pillars (3) or the different arrays (1) on the substrate may not be symmetrical with respect to central axis of the carrier substrate (2). However, each individual pillar (3) can be symmetric to its central axis. If the pattern of pillars as a whole is not symmetric to the central axis (L), the possibilities for conformal deposition of layers are very limited. Since patterns which are non-symmetric with respect to a (global) central axis are often utilized, ALD offers the only possibility to deposit conformal layers (or zones) of the FZP to these substrates.

So far, deposition of full material FZPs onto any other material than smooth glass fiber cores resulted in poor quality layer structures. Glass fibers provide a high circularity and smooth surface compared to metallic or ceramic fibers by its amorphous nature therefore limiting the substrate usage mostly to glass fibers. One further advantage of the method described here is that it vastly expands the possibly available materials as the substrate. Polymeric, single crystalline silicon and gold substrates have been utilized for fabrication of the pillar arrays (1) described here. However, one can envision utilization of a vast number of heat resistant polymeric, metallic, amorphous metallic, ceramic, glass, glass-ceramic and diamond based materials for the realization of the micro-pillars (3). When utilized, some of the high Z materials such as gold or lead can also act as a central stop to improve imaging contrast thus adding further advantage by avoiding the need for an external beamstop or a beamstop deposition onto the center of the full material FZP.

In a preferred embodiment the deposition process comprises the step of application of area selective ALD. One possible way would be to apply a hydrophobic material on the substrate and the top (6) of the micro pillars (3) but not onto the sidewalls. This can be achieved, for instance, by selectively functionalizing all horizontal planes with a Self-Assembled Monolayer (SAM) via a use of a proper molecule. This will ensure no deposition on those surfaces, enabling the deposition to happen only on the side walls (8) of the micro pillars (3). Figure 5 schematically shows 4 steps of the deposition procedure. In step 1 the micro pillars (3) are provided. They are arranged on a common carrier (2) which is preferably a substrate which is transparent for X-rays. In step 2 a coating (9) is applied onto the surfaces (6) of the micro-pillars (3) onto which no layers should be deposited by ALD. Some of these surfaces (6, 7) which usually are coated are the substrate surface (7) and the top surface (6) of the micro pillars (3). Depending on the precursor type, the coating (9) might be a hydrophobic material. By this process ALD becomes an area selective ALD process. Covering of the top (6) of the micro-pillars (3), and the bottom of the substrate (7), except for the walls (8) of the micro-pillars (3) with a hindering material prior to atomic layer deposition, will enable area selective deposition of the multilayer zones only on the walls (8) of the micro-pillars (3). So far all the methods for fabricating multilayer type or sputter sliced FZPs needed FIB slicing (or other more crude methods) and mounting on a grid. The selective deposition method eliminates the need for FIB slicing, and hundreds or even thousands of FZPs can be fabricated in a two-step process.

In step 3 the alternating layers are deposited by ALD onto all non-coated surfaces (8). ALD is known from the prior art and will be described in more detail later. Because of the coating, ALD can be performed area selectively and the multilayer zones of the FZP can be deposited selectively onto the side walls (8) of the micro pillars (3). After deposition of the layers by ALD is completed, the coating (9) can be removed as illustrated in step 4. It remains a Fresnel Zone Plate array (1). If desired single FZP can be sliced down from this array and handled/used individually.

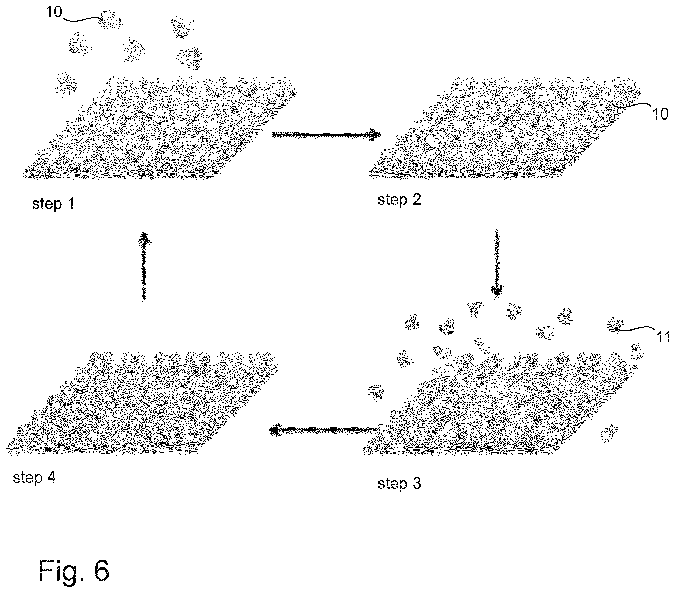

Figure 6 illustrates the single steps of an ALD-cycle. This technique is well known in the prior art. Thus, it is only described briefly. In step 1, a first precursor (10) is added to the reaction chamber (not shown) containing the material surface (the side walls (8) of the pillars (3)) to be coated. The first precursor (10) is added in large excess into the reaction chamber. Thus, it is adsorbed on the entire surface. Any excess of the first precursor (10) is removed from the reaction chamber in step 2. The molecules of the first precursor (10) react on the surface. Then, a second precursor (11) is added in step 3. It reacts with the new surface to create another layer on the surface. The second precursor (11) is then removed from the reaction chamber and a homogeneous layer remains on the original surface. This process is repeated until a desired thickness for the respective layer is achieved. Then, the precursors are changed and the process is repeated for the next layer of another material. The deposition of the layers of different materials is repeated until the desired number of layers is deposited.

A tremendous advantage of ALD over other methods is that it is the only method for applying the individual layers onto the sidewalls of the pillars without rotation of the pillar (3) itself with respect to its central axis (L), hence making the process described here possible. Furthermore, because of the large excess of the precursor and their gas state, the individual molecules can easily reach every surface area, even within the holes or recesses (4) in which each individual pillar (3) is located (by using the FIB). Since the excess of precursor molecules is purged away (Fig. 6, steps 2 and 4) a homogeneous new surface layer remains even in areas with sharp edges or narrow corners. This method allows fabricating FZPs having outermost zone widths smaller than 10 nm, preferably smaller than 5 nm and most preferred smaller than 1 nm with extremely high aspect ratios compared to the FZPs fabricated by lithography techniques.

Thus, ALD allows
- precise and conformal deposition through complementary, self-limiting, surface reactions;
- uniform thickness and conformal coating; and
- highly precise thickness control through controlling the number of cycles
- large selection of materials relevant for X-ray optics such as oxides, nitrides and pure metals

Preferably plasma enhanced ALD is used for fast deposition. It allows a PE-SiO₂ growth rate and/or deposition rate of 2.6 µm/day.

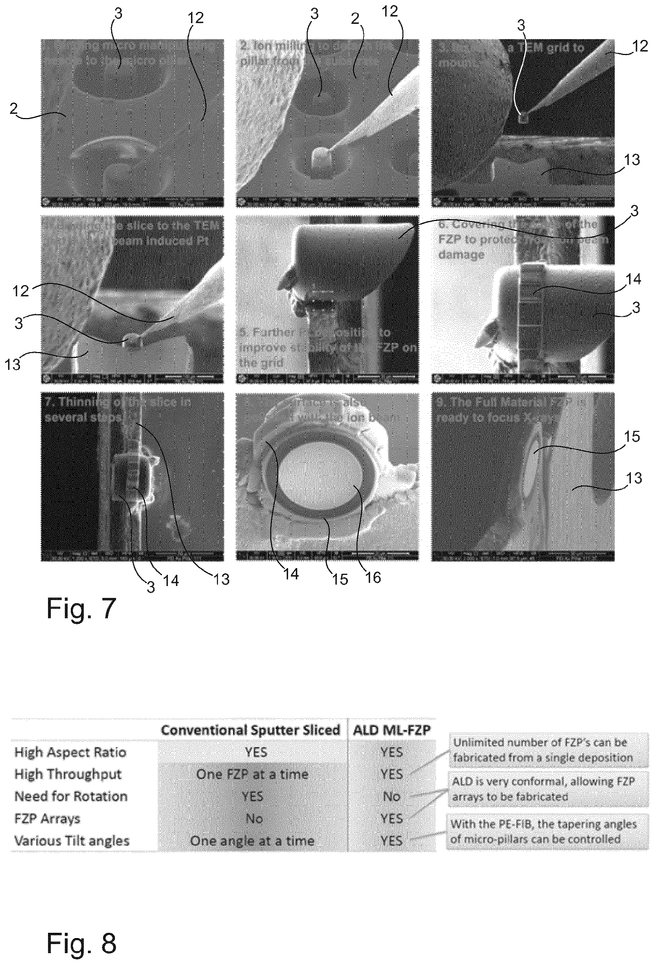

If it is not desired to use the array of FZPs as a whole and/or if single FZPs are needed, single full material FZPs with optimum tilt angels can be sliced from the array and transferred on grids. A preferred embodiment of this process is illustrated in Fig. 7.

As shown in Fig. 7.1 a micro manipulating needle (12) is bound to the micro-pillar (3). Then the pillar (3) is detached from the substrate (2) as illustrated in Fig. 7.2. After providing a TEM grid (13) to mount, the sliced pillar (3) is bound to it (Figs. 7.3 and 7.4). Binding of the sliced pillar (3) can e.g. be performed via ion beam induced Pt deposition. After the sliced pillar (3) is bound to the mount (13), the needle can be detached. If necessary, a further material (e.g. Pt) can be deposited between the sliced pillar (3) and the mount (13) to improve the stability of the sliced pillar (3) on the grid (13) (Fig. 7.5).

As shown in Fig. 7.5 the sliced pillar (3) is still far away from the ideal geometry of a FZP with parallel and planar surfaces. Thus, it has to be thinned further. A preferred method for slicing an FZP out of the pillar (3) via an ion beam is shown in Figures 7.6 - 7.9. Therefore, the FZP has to be protected from ion beam damage. Thus, the sides of the FZP are covered by a material layer (14) in the desired length as illustrated in Fig. 7.6. Then, the pillar (3) is sliced to the desired length. As mentioned, ion beam techniques can preferably be used. Fig. 7.7 shows a pillar (3) which has been already sliced (on the left side), but is still much longer than the desired FZP which is protected by the covering (14) of the sidewalls. Slicing by ion beam techniques is preferred because ion beams can also be used for polishing the parallel and planar surfaces of the FZP (15) after it has been sliced to the desired length. A polished surface (16) is shown in Fig. 7.8. Fig. 7.9 shows a full material FZP (15) mounted on a grid (13). This FZP (15) can be used to focus X-rays. Since the length of the FZP can be adapted to specific need during or after its mounting on the grid, this method allows not only to fabricate FZPs (15) having sub nm outermost zone widths but also having extremely high aspect ratios.

Some advantages of the high resolution full material Fresnel Zone Plate array (column ALD ML-FZP) and the process for its fabrication are summarized in Fig. 8.

### Examples

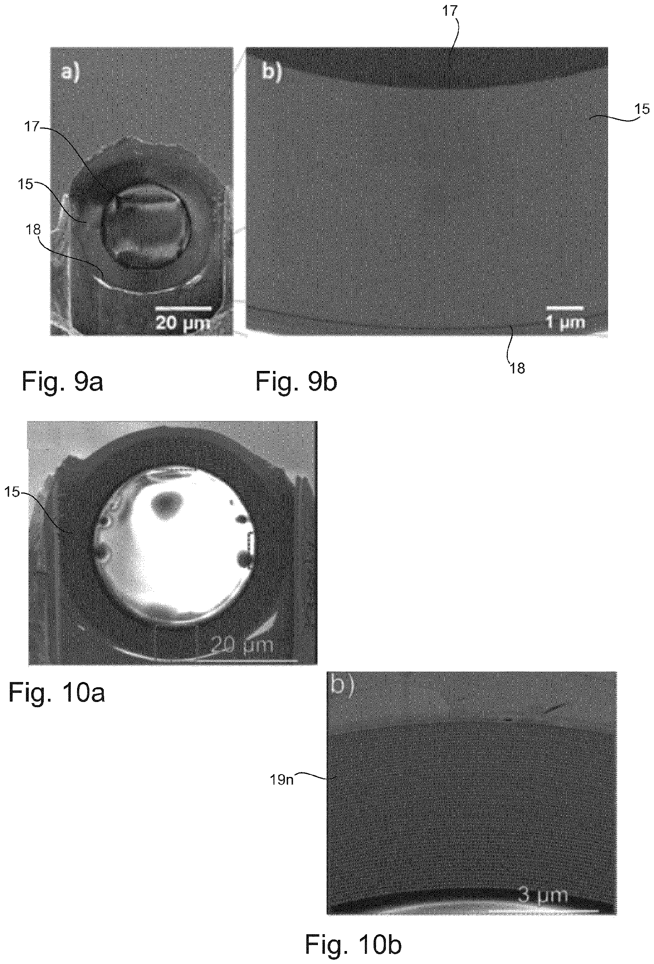

An SEM image of one ML-FZPs (15) is shown in Figures 9a) and 9b). Being monolithic optics, ML-FZPs (15) are easy to align, have a point focus, and they can be efficient in a very wide X-ray energy range. The layers are deposited on a glass substrate. The central glass fiber core (17) will be deposited with Pt to act as a beam stop. The shown FZP (15) has a diameter d = 44 µm. The outermost zone (18) has a width Δr = 20 nm and a deposition thickness of 6.5 µm. With such an ML-FZP (15), a half-pitch imaging resolution of 15.5 nm could be achieved. This is currently the highest imaging resolution reported for a multilayer type FZP (15). However, by the fabrication route via FZP arrays (1) or controlled tilt angles (α), resolutions below 10 nanometer for focusing of hard and soft X-rays to through ML-FZPs, are possible.

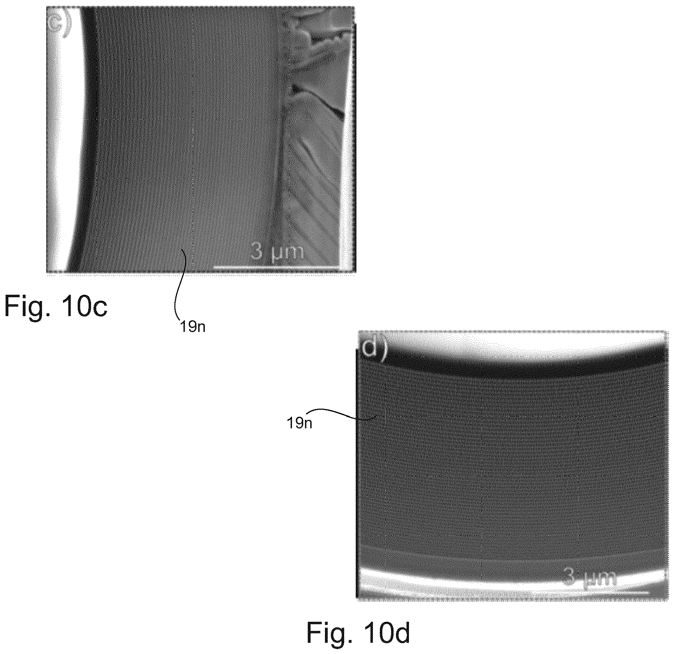

In addition to the FZP (15) shown in Fig. 9 also the example of Fig. 10 illustrates the extremely high accuracy of the zones (19) of the multilayer FZP (15). Fig. 10a) is an SEM image of a single FZP (a) cut-out of an ALD deposit. The areas marked with rectangles in Fig. 10a) are shown in more detail in Figs. 10b) - d). Fig. 10b) is a detailed view of the uppermost rectangle (red), Fig. 10c) is a detailed view of the right rectangle (blue) and Fig. 10d) is a detailed view of the lowermost rectangle (green). In all these detailed figures 10 b) - d)the individual layers (19n) and their diminishing width with larger distance to the central axis can be seen.

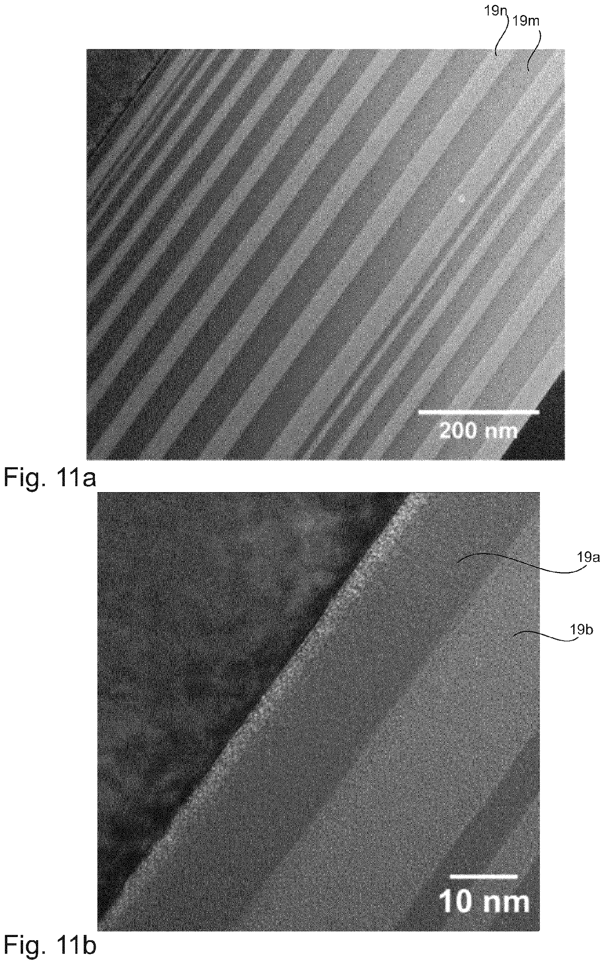

The sharp edges between individual layers (e.g. 19n and 19m or 19a and 19b) and the low roughness are illustrated even better in Fig. 11a) and b). These figures are TEM images of an Al₂O₃-SiO₂ multilayer. With current processes 20 µm multilayers of Al₂O₃-SiO₂ could be deposited within less than 9 days.

Since the accuracy of each single layer (e.g. 19n, 19m, 19a or 19b) is extremely high, a very large number of layers in the range of thousands (19) can be applied onto a substrate without propagation of irregularities to further layers (19). Thus, the deposition thickness can be improved.

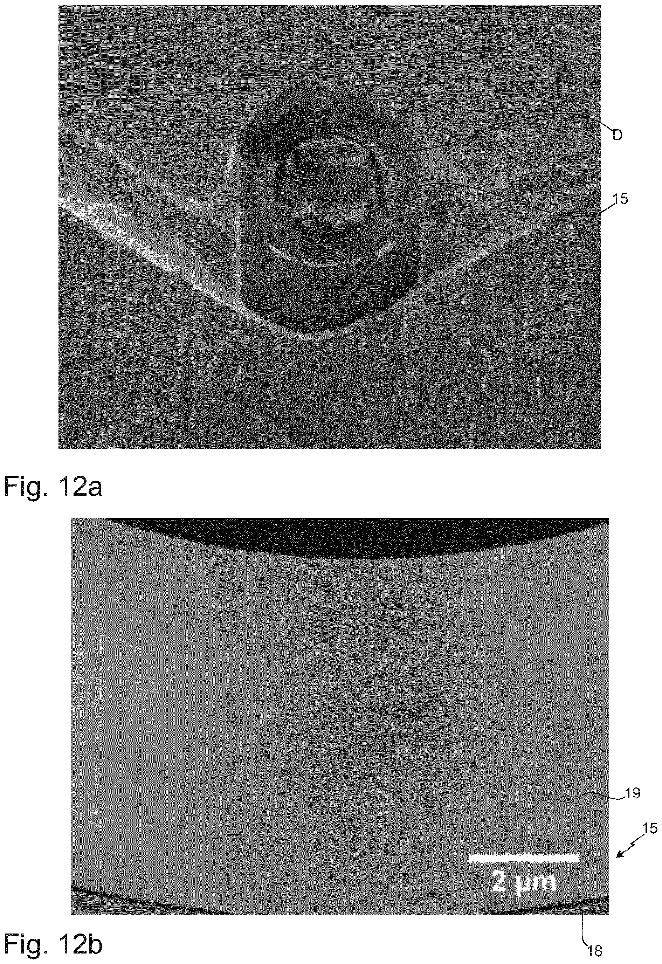

Fig. 12a) shows an ML-FZP (15) of Al₂O₃-HfO₂ Δr = 20 nm with an overall deposition (D) of 6.5 µm.

Fig. 12b) is a detailed view of the ML-FZP (15) of Al₂O₃-HfO₂ shown in Fig. 12a) and illustrates that even at this extreme thickness (D), the accuracy of the outer layers (19x - 19z) and the outermost layer (18) is still extremely high.

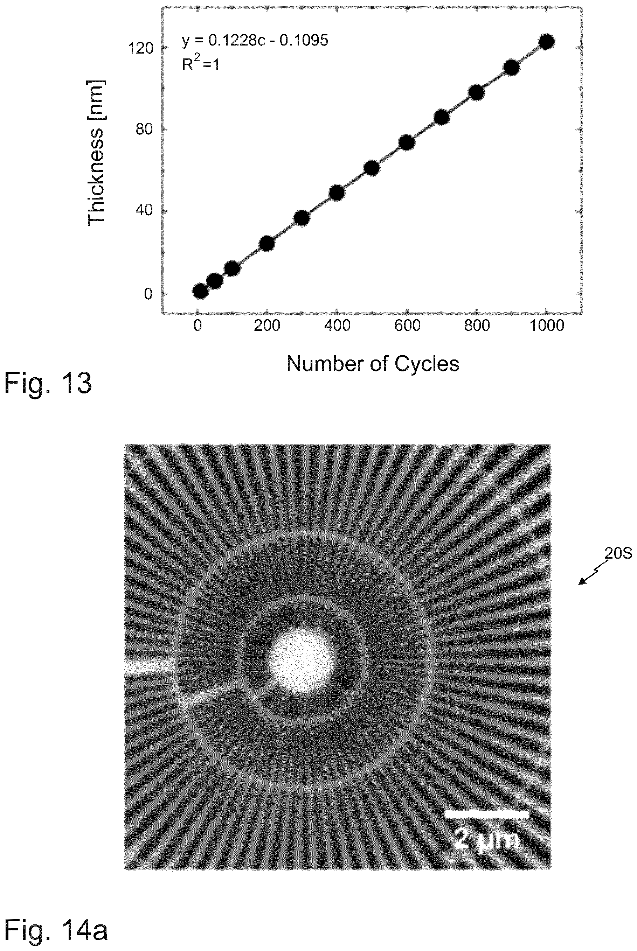

Since ALD is a cycle based deposition, it could be expected that the growth per cycle follows a linear curve. However, the correlation has been checked. The results are illustrated in Fig. 13. The linear correlation could be confirmed.

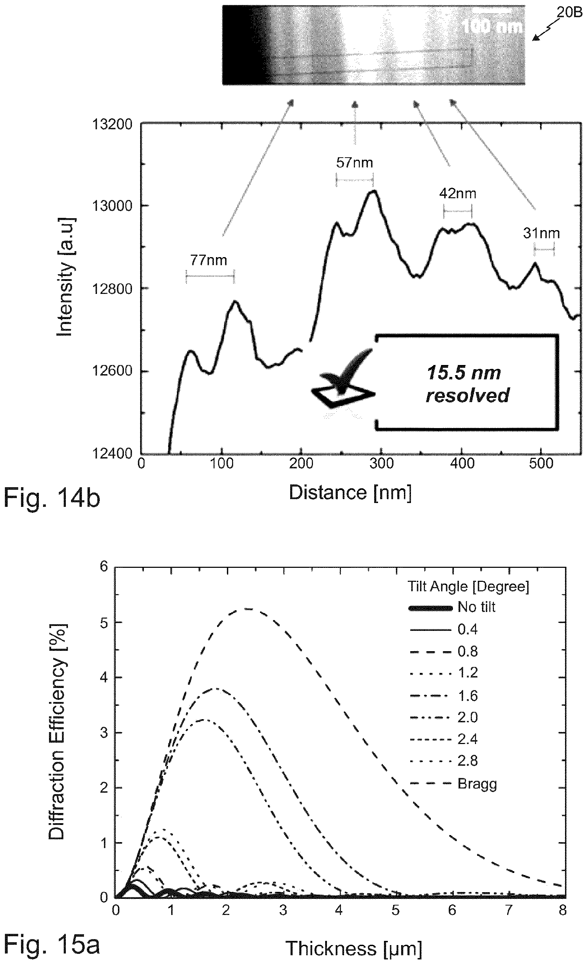

Direct imaging results which have been obtained at BESSY II are shown in Fig. 14a) and b). Figure a) shows an STXM image (20S) of a Siemens star taken at 1 keV, 10 nm step size and 5 ms pixel dwell time and figure b) an STXM image (20B) of the BAM L-200 sample taken at BESSY UE46-PGM2. Step size 4 nm. Dwell time 30 ms. The full pitch cut-off resolution is 31 nm corresponding to 15.5 nm half pitch resolution. In Fig. a) an FZP with Δr = 35 nm is used whereas the Fig b) is taken by using an FZP with an outermost zone width of 25 nm.

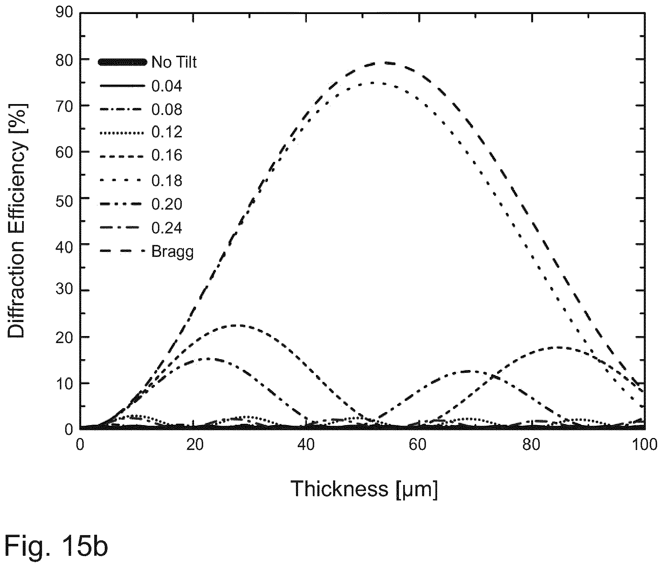

Furthermore diffraction efficiency calculations have been performed. For illustration purposes a selected FZP of different materials, the results are illustrated in Figures 15a) and b). Fig. 15a) shows the expected diffraction efficiency vs thickness graphs calculated by using the coupled wave theory (CWT) of Al₂O₃-SiO₂ ML-FZP with tilted zones for 1 keV X-rays. Fig. 15b) shows the expected diffraction efficiency vs thickness graphs calculated by using the coupled wave theory (CWT) of Al₂O₃-SiO₂ ML-FZP with tilted zones for 10 keV X-rays. Both calculations were performed with the following parameters: Diameter D = 40 µm, Outermost zone width Δr = 10 nm, d(Al₂O₃) = 2.99 g\cm³, d(SiO₂) = 2.11 g\cm³.

For X-rays from 1 to 1.6 keV, an imaging resolution of 15.5 nm could be achieved at a measured efficiency from 3 to 12.5 % for the material system Al₂O₃-HfO₂/Ta₂O₅.

For X-rays of 7.9 keV, a focal spot of 30 nm could be achieved at a measured efficiency of 15.6 % for the material system Al₂O₃-Ta₂O₅.

All the features disclosed in the application documents are claimed as being essential to the invention, insofar as they are novel either individually or in combination as compared with the prior art.

## Claims

1. Full material Fresnel Zone Plate precursor array, wherein a plurality of full material Fresnel Zone Plate precursors is arranged on a common carrier and the Fresnel Zone Plate precursors are micro-pillars
**characterized in that**
the full material Fresnel Zone Plate precursors have controlled tapering angles and these tapering angles differ between some of the Fresnel Zone Plate precursors arranged on the same common carrier.

2. Full material Fresnel Zone Plate precursor array according claim 1,
**characterized in that**
the full material Fresnel Zone Plate precursors are spaced apart from each other on the common carrier.

3. Full material Fresnel Zone Plate precursor array according claim 1 or 2,
**characterized in that**
the central axis of the full material Fresnel Zone Plate precursors are arranged parallel to each other on the common carrier.

4. Full material Fresnel Zone Plate precursor array according to at least one of the preceding claims,
**characterized in that**
the central axes of the full material Fresnel Zone Plate precursors are arranged parallel to the surface normal of the common carrier.

5. Method for producing a full material Fresnel Zone Plate precursor array,
**characterized by the steps**
a) Providing a common carrier comprising a plurality of micro-pillars,
b) Deposition of alternating layers of at least two different materials onto at least some of the micro-pillars,
Wherein the full material Fresnel Zone Plate precursors have controlled tapering angles and these tapering angles differ between some of the Fresnel Zone Plate precursors arranged on the same common carrier.

6. Method according claim 5,
**characterized in that**
the plurality of micro-pillars is produced by at least one process selected from the group comprising
- Focused ion beam (FIB) milling,
- Plasma focused ion beam (Plasma-FIB) milling,
- Spin-coating combined with Direct Laser writing or two photon photopolymerization or any other microprinting method,
- Direct laser ablation,
- A combination of any optical, electron, ion beam lithography or any directed-self-assembly or self-assembly method to form a mask layer followed by reactive ion etching (RIE), deep reactive ion etching (DRIE) or a chemical etching method.

7. Method according claim 5 or 6,
**characterized in that**
deposition of the alternating layers is performed via selective or non-selective, atomic layer deposition (ALD).

8. Method according to at least one of claims 5 - 7,
**characterized in that**
deposition of the alternating layers is performed simultaneously on a plurality of micro-pillars.

9. Method according to at least one of claims 5 - 8,
**characterized in that** the method further comprises the step of c)
detaching at least one micro-pillar from the common carrier after deposition of the alternating layers on this micro-pillar.

10. Method according to at least one of claims 5 - 9,
**characterized in that** the method further comprises the step of d)
slicing a full material Fresnel Zone Plate out of a pillar after deposition of the alternating layers on it, preferably by means of an ion beam.

11. Method according to at least one of claims 5 - 10,
**characterized in that**
at least some of the micro-pillars are produced to be parallel with respect to each other.

12. Method according to at least one of claims 9 - 11,
**characterized in that**
the detached micro-pillar is bound to a mount, preferably a TEM mount, preferably via ion beam induced metal deposition, most preferably via ion beam induced Pt deposition.

13. Method according to at least one of claims 5 - 12,
**characterized in that**
steps a) and b) are performed independently from each other.

14. An apparatus for producing a full material Fresnel Zone Plate precursor array,
**characterized in that** it comprises
a) A first device for providing a plurality of micro-pillars in a common carrier,
b) A deposition device which applies alternating layers of at least two different materials onto at least some of the micro-pillars arranged on the common carrier and
c) A slicing device which slices a full material Fresnel Zone Plate out of a pillar, wherein the full material Fresnel Zone Plate precursors have controlled tapering angles and these tapering angles differ between some of the Fresnel Zone Plate precursors arranged on the same common carrier.

## Patentansprüche

1. Vollmaterial-Fresnel-Zonenplattenvorläuferarray, wobei eine Vielzahl von Vollmaterial-Fresnel-Zonenplattenvorläufern auf einem gemeinsamen Träger angeordnet sind und die Fresnel-Zonenplattenvorläufer Mikrosäulen sind,
**dadurch gekennzeichnet, dass**
die Vollmaterial-Fresnel-Zonenplattenvorläufer kontrollierte Verjüngungswinkel aufweisen und sich diese Verjüngungswinkel einiger der Fresnel-Zonenplattenvorläufer, welche auf demselben gemeinsamen Träger angeordnet sind, voneinander unterscheiden.

2. Vollmaterial-Fresnel-Zonenplattenvorläuferarray nach Anspruch 1,
**dadurch gekennzeichnet, dass**
die Vollmaterial-Fresnel-Zonenplattenvorläufer auf dem gemeinsamen Träger voneinander beabstandet sind.

3. Vollmaterial-Fresnel-Zonenplattenvorläuferarray nach Anspruch 1 oder 2,
**dadurch gekennzeichnet, dass**
die Mittelachsen der Vollmaterial-Fresnel-Zonenplattenvorläufer parallel zueinander auf dem gemeinsamen Träger angeordnet sind.

4. Vollmaterial-Fresnel-Zonenplattenvorläuferarray nach zumindest einem der vorhergehenden Ansprüche,
**dadurch gekennzeichnet, dass**
die Mittelachsen der Vollmaterial-Fresnel-Zonenplattenvorläufer parallel zu der Oberflächennormalen des gemeinsamen Trägers angeordnet sind.

5. Verfahren zum Herstellen einer Vollmaterial-Fresnel-Zonenplattenvorläuferarray, **gekennzeichnet durch** die Schritte
a) Bereitstellen eines gemeinsamen Trägers umfassend eine Vielzahl von Mikrosäulen,
b) Abscheiden von alternierenden Schichten von mindestens zwei verschiedenen Materialien auf mindestens einige der Mikrosäulen,
wobei die Vollmaterial-Fresnel-Zonenplattenvorläufer kontrollierte Verjüngungswinkel aufweisen und sich diese Verjüngungswinkel einiger der Fresnel-Zonenplattenvorläufer, welche auf demselben gemeinsamen Träger angeordnet sind, voneinander unterscheiden.

6. Verfahren nach Anspruch 5,
**dadurch gekennzeichnet, dass**
die Vielzahl von Mikrosäulen mittels mindestens eines Prozesses hergestellt ist, ausgewählt aus der Gruppe umfassend
- fokussiertes Ionenstrahl(FBI)-Fräsen,
- Plasma-fokussiertes Ionenstrahl(FBI)-Fräsen,
- Rotationsbeschichtung kombiniert mit Direktem Laserschreiben oder Zwei-Photonen-Photopolymerisation oder jeglichem anderen Mikroschriftverfahren,
- Direkte Laserabtragung,
- eine Kombination jeglicher optischer, Elektronen-, lonenstrahllithografie oder jeglicher gerichteter Selbstanordnungs- oder Selbstanordnungsverfahren zum Formen einer Maskierungsschicht gefolgt von reaktivem lonenätzen (RIE), tiefem reaktivem lonenätzen (DRIE) oder einem chemischen Ätzverfahren.

7. Verfahren nach Anspruch 5 oder 6,
**dadurch gekennzeichnet, dass**
das Abscheiden der alternierenden Schichten mittels selektiver oder nicht-selektiver Atomlagenabscheidung (ALD) durchgeführt wird.

8. Verfahren nach zumindest einem der Ansprüche 5 - 7,
**dadurch gekennzeichnet, dass**
das Abscheiden der alternierenden Schichten gleichzeitig auf einer Vielzahl von Mikrosäulen durchgeführt wird.

9. Verfahren nach zumindest einem der Ansprüche 5 - 8,
**dadurch gekennzeichnet, dass** das Verfahren den weiteren Schritt umfasst c)
Ablösen mindestens einer Mikrosäule von dem gemeinsamen Träger nach Abscheiden der alternierenden Schichten auf dieser Mikrosäule.

10. Verfahren nach zumindest einem der Ansprüche 5 - 9,
**dadurch gekennzeichnet, dass** das Verfahren den weiteren Schritt umfasst d)
Schneiden einer Vollmaterial-Fresnel-Zonenplatte aus einer Säule nach Abscheiden der alternierenden Schichten darauf, bevorzugt mittels eines lonenstrahls.

11. Verfahren nach zumindest einem der Ansprüche 5 - 10,
**dadurch gekennzeichnet, dass**
mindestens einige der Mikrosäulen hergestellt werden, um parallel zueinander zu sein.

12. Verfahren nach zumindest einem der Ansprüche 5 - 11,
**dadurch gekennzeichnet, dass**
die abgelöste Mikrosäule an eine Halterung gebunden wird, bevorzugt eine TEM Halterung, bevorzugt mittels lonenstrahl-induzierter Metallabscheidung, insbesondere bevorzugt mittels lonenstrahl-induzierter Pt-Abscheidung.

13. Verfahren nach zumindest einem der Ansprüche 5 - 12,
**dadurch gekennzeichnet, dass**
die Schritte a) und b) unabhängig voneinander ausgeführt werden.

14. Ein Gerät zum Herstellen eines Vollmaterial-Fresnel-Zonenplattenvorläuferarrays, **dadurch gekennzeichnet, dass** dieses umfasst
a) eine erste Vorrichtung zum Bereitstellen einer Vielzahl von Mikrosäulen in einem gemeinsamen Träger,
b) eine Abscheidungsvorrichtung, welche alternierende Schichten von mindestens zwei unterschiedlichen Materialen auf mindestens einige der Mikrosäulen, welche auf dem gemeinsamen Träger angeordnet sind, appliziert
und
c) eine Schneidevorrichtung, welche eine Vollmaterial-Fresnel-Zonenplatte aus einer Säule schneidet,
wobei die Vollmaterial-Fresnel-Zonenplattenvorläufer kontrollierte Verjüngungswinkel aufweisen und sich diese Verjüngungswinkel einiger der Fresnel-Zonenplattenvorläufer, welche auf demselben gemeinsamen Träger angeordnet sind, voneinander unterscheiden.

## Revendications

1. Réseau de précurseurs de plaques à zones de Fresnel en matériau plein, dans lequel une pluralité de précurseurs de plaques à zones de Fresnel en matériau plein sont disposés sur un support commun et les précurseurs de plaques à zones de Fresnel sont des micro-piliers,
**caractérisé par le fait que**
les précurseurs de plaques à zones de Fresnel en matériau plein ont des angles de conicité contrôlés et ces angles de conicité diffèrent entre certains des précurseurs de plaques à zones de Fresnel disposés sur le même support commun.

2. Réseau de précurseurs de plaques à zones de Fresnel en matériau plein selon la revendication 1,
**caractérisé par le fait que**
les précurseurs de plaques à zones de Fresnel en matériau plein sont espacés les uns des autres sur le support commun.

3. Réseau de précurseurs de plaques à zones de Fresnel en matériau plein selon la revendication 1 ou 2,
**caractérisé par le fait que**
les axes centraux des précurseurs de plaques à zones de Fresnel en matériau plein sont disposés parallèlement les uns aux autres sur le support commun.

4. Réseau de précurseurs de plaques à zones de Fresnel en matériau plein selon au moins une des revendications précédentes,
**caractérisé par le fait que**
les axes centraux des précurseurs de plaques à zones de Fresnel en matériau plein sont disposés parallèlement à la normale à la surface du support commun.

5. Procédé de production d'un réseau de précurseurs de plaques à zones de Fresnel en matériau plein,
**caractérisé par** les étapes :
a) disposer un support commun comprenant une pluralité de micro-piliers,
b) déposer des couches alternées d'au moins deux matériaux différents sur au moins certains des micro-piliers,
les précurseurs de plaques à zones de Fresnel en matériau plein ayant des angles de conicité contrôlés et ces angles de conicité étant différents entre certains des précurseurs de plaques à zones de Fresnel disposés sur le même support commun.

6. Procédé selon la revendication 5,
**caractérisé par le fait que**
la pluralité de micro-piliers est produite par au moins un traitement choisi parmi le groupe comprenant :
- fraisage par faisceau ionique focalisé (FIB),
- fraisage par faisceau ionique focalisé à plasma (FIB-plasma),
- une technique de dépôt par rotation combinée à une écriture directe par laser ou une photopolymérisation à deux photons ou tout autre procédé de micro-impression,
- ablation directe par laser,
- une combinaison de n'importe quelle lithographie optique, par électrons, par faisceau ionique ou de n'importe quel procédé à auto-assemblage ou à auto-assemblage dirigé pour former une couche de masque suivie d'une gravure ionique réactive (RIE), d'une gravure ionique réactive profonde (DRIE) ou d'un procédé de gravure chimique.

7. Procédé selon la revendication 5 ou 6,
**caractérisé par le fait que**
le dépôt des couches alternées est réalisé par l'intermédiaire d'un dépôt de couches atomiques (ALD) sélectif ou non-sélectif.

8. Procédé selon au moins une des revendications 5 à 7,
**caractérisé par le fait que**
le dépôt des couches alternées est réalisé simultanément sur une pluralité de micro-piliers.

9. Procédé selon au moins une des revendications 5 à 8,
**caractérisé par le fait que**
le procédé comprend en outre l'étape :
c) détacher au moins un micro-pilier du support commun après le dépôt des couches alternées sur ce micro-pilier.

10. Procédé selon au moins une des revendications 5 à 9,
**caractérisé par le fait que** le procédé comprend en outre l'étape :
d) découper une plaque à zones de Fresnel en matériau plein à partir d'un pilier après le dépôt des couches alternées sur celui-ci, de préférence au moyen d'un faisceau ionique.

11. Procédé selon au moins une des revendications 5 à 10,
**caractérisé par le fait qu'**au moins certains des micro-piliers sont produits pour être parallèles les uns par rapport aux autres.

12. Procédé selon au moins une des revendications 9 à 11,
**caractérisé par le fait que**
le micro-pilier détaché est lié à une monture, de préférence une monture TEM, de préférence par l'intermédiaire d'un dépôt de métal induit par faisceau ionique, de la façon que l'on préfère le plus par l'intermédiaire d'un dépôt de Pt induit par faisceau ionique.

13. Procédé selon au moins une des revendications 5 à 12,
**caractérisé par le fait que**
les étapes a) et b) sont réalisées indépendamment l'une de l'autre.

14. Appareil pour produire un réseau de précurseurs de plaques à zones de Fresnel en matériau plein,
**caractérisé par le fait qu'**il comprend :
a) un premier dispositif pour fournir une pluralité de micro-piliers dans un support commun,
b) un dispositif de dépôt qui applique des couches alternées d'au moins deux matériaux différents sur au moins certains des micro-piliers disposés sur le support commun, et
c) un dispositif de découpage qui découpe une plaque à zones de Fresnel en matériau plein à partir d'un pilier,
les précurseurs de plaques à zones de Fresnel en matériau plein ayant des angles de conicité contrôlés et ces angles de conicité étant différents entre certains des précurseurs de plaques à zones de Fresnel disposés sur le même support commun.
